# EUROPEAN PATENT APPLICATION

(11) **EP 3 214 750 A1**
(43) Date of publication of application: **06.09.2017**
(21) Application number: 17158759.5
(22) Date of filing: 01.03.2017
(51) Int. Cl.: H02M 7/493, H02M 1/12, H02M 1/00, H02M 3/158

(54) **INTERPHASE REACTOR AND PARALLEL CONVERTERS USING SUCH A REACTOR**

(30) Priority: 03.03.2016 US 201615059384
(71) Applicant: Hamilton Sundstrand Corporation, Charlotte, NC 28217-4578 (US)
(72) Inventor: FENG, Frank Z., Loves Park, IL Illinois 61111-8918 (US); WHITE, Adam Michael, Cherry Valley, IL Illinois 61016 (US)
(74) Representative: Bridge, Kerry Ann

(57) **Abstract**

A parallel semiconductor switching system includes an input filter circuit, a plurality of switching circuits (106a-b), and a current-sharing filter inductor. The switching circuits (106a-b) receive the filtered voltage generated by the input filter circuit, and each switching circuit outputs a respective current. The current-sharing filter inductor includes a plurality of windings (110a-n). Each winding has a winding input and a winding output. The winding input of each winding is connected to a switching output of a respective switching circuit, and the winding output of each winding is connected to one another to form a common node (112). The common node (112) is connected directly to a load such that the cument-sharing filter inductor shares each current output from the plurality of switching circuits so as to deliver a combined current to the load.

## Description

### TECHNICAL FIELD

Various embodiments relate generally to aircraft systems, and more particularly, to electronic motor control systems.

### BACKGROUND

Aircraft electrical systems typically include one or more motor controllers to drive high power motors at various locations via long cables. To save vehicle weight, the cables used to deliver the high-power are unshielded. Since the cables are unshielded, however, an increased level of electromagnetic interference may be emitted.

To account for high current loads, motor controllers may implement a plurality of semiconductor switches connected in a parallel and a passive power filter to address EMI and Power Quality requirements. Standard semiconductor switches are typically available in discrete current ratings such as, for example, 100 amps (A), 200A, 300A, etc. These parallel switches, however, do not inherently share current equally. To compensate for the unequal current-sharing, the parallel switching arrangement used to drive the high-power motors are operated below rated current values. Additionally, the total power conversion efficiency provided by the unequal current-sharing parallel switching arrangement is lower than the ideal case for equal current-sharing switches.

### SUMMARY

According to a non-limiting embodiment, a parallel semiconductor switching system includes an input tilter circuit, a plurality of switching circuits, and a current-sharing filter inductor. The switching circuits receive the filtered voltage signal (e.g., filter voltage) generated by the input filter circuit, and each switching circuit outputs a respective current signal (e.g., electrical current). The current-sharing filter inductor includes a plurality of windings. Each winding has a winding input and a winding output. The winding input of each winding is connected to a switching output of a respective switching circuit, and the winding output of each winding is connected to one another to form a common node. The common node is connected directly to a load such that the current-sharing filter inductor assists sharing of load current among plurality of switching circuits.

According to another non-limiting embodiment, a method of sharing current generated by a parallel semiconductor switching system to drive a load comprises generating at least one filtered voltage, delivering the filter voltage to a plurality of parallel switching circuits, and generating a plurality of individual current signals (e.g., individual electrical currents). The method further includes delivering each current to a respective winding and combining the winding currents at a common node to generate a combined current signal (e.g., a combined current). The method further includes outputting the combined current directly to a load so as to drive the load.

According to still another non-limiting embodiment, a filter inductor is configured to share current generated by a plurality of switching circuits included in a parallel semiconductor switching system. The filter inductor comprises a core element, a first winding, and a second winding. The first winding extends from a first proximate terminal end to an opposing first distal terminal end, and the second winding extends from a second proximate terminal end to an opposing second distal terminal end. The first and second windings are wrapped around the core element at an alternating sequential arrangement with respect to one another.

### BRIEF DESCRIPTION OF THE DRAWINGS

The subject matter which is regarded as the present disclosure is particularly pointed out and distinctly claimed in the claims at the conclusion of the specification. The foregoing and other features, and advantages of the present disclosure are apparent from the following detailed description taken in conjunction with the accompanying drawings in which:
FIG. 1A is a schematic diagram of a conventional parallel semiconductor switching system;
FIG. 1B illustrates a conventional reactor utilized in the conventional parallel semiconductor switching system of FIG. 1A;
FIG. 1C illustrates another conventional reactor utilized in the conventional parallel semiconductor switching system of FIG. 1A;
FIG. 2A is a schematic diagram of a parallel semiconductor switching system including a filter inductor configured to provide current sharing according to a non-limiting embodiment;
FIG. 2B is a schematic diagram of the parallel semiconductor switching system of FIG. 2A illustrating an equivalent circuit diagram of the current-sharing filter inductor;
FIG. 3 illustrates a filter inductor configured to provide current sharing according to a non-limiting embodiment;
FIG. 4 is a schematic diagram of a multi-level two-branch parallel semiconductor switching system including a filter inductor configured to provide current sharing according to another non-limiting embodiment; and
FIG. 5 is a schematic diagram of a N-branch parallel semiconductor switching system including a filter inductor configured to provide current sharing according to another non-limiting embodiment.

### DETAILED DESCRIPTION

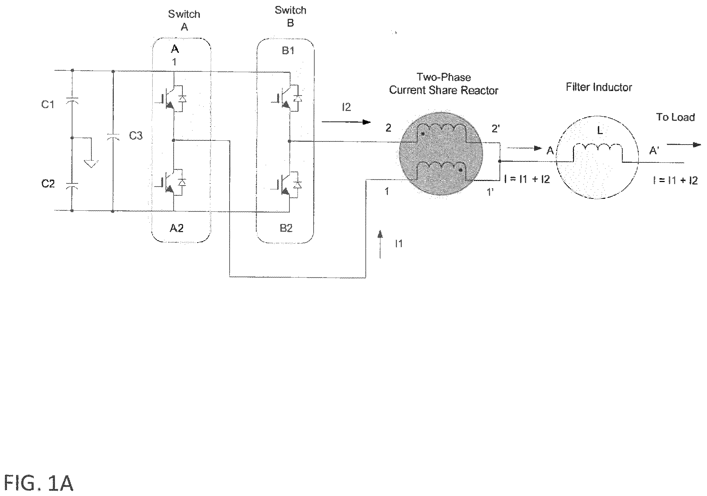

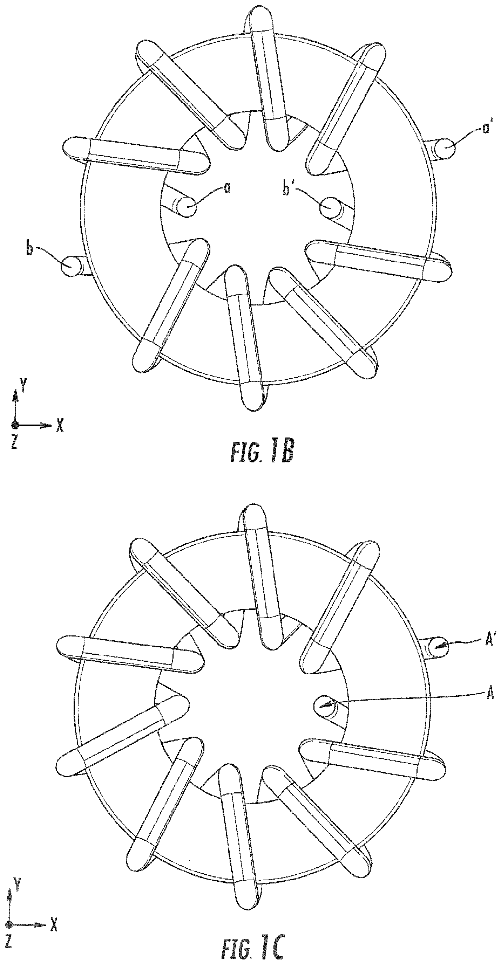

Traditional parallel topology high-power switching assemblies such as those illustrated in FIG. 1A typically include two branches of current flow (*e.g*., I_{A} and I_{B}) from switches that are connected via a two-phase current sharing reactor. The fundamental frequency components of the two branches I_{A} and I_{B} are in phase. The motor current fundamental frequency component (I) is shared due to the action of the current sharing reactor. These traditional parallel topology high-power switching assemblies typically include a separate filter inductor as shown in FIGS. 1B and 1C. With respect to the conventional reactor illustrated in FIG. 1C, the reaction has one winding to form lump inductance (L) between two opposing terminals (*e.g*., terminal a and terminal a') of the winding.

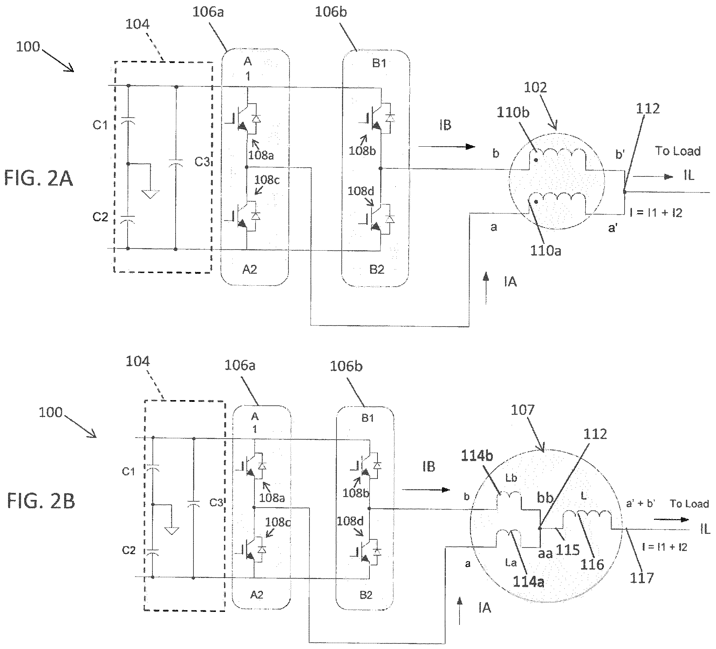

Various non-limiting embodiments of the invention, however, provide multi-level parallel semiconductor switching system including a plurality of switching branches. The output of each respective switching branch is connected to individual input terminals included with a multi-winding filter inductor. The leakage inductances of each winding (*e.g*., La and Lb) may reach approximately 2% of the lump inductance such that the sum of the leakage inductances La + Lb may serve as a current sharing reactor In addition, the filter inductor according to at least one embodiment does not require a separate individually connected device serving as a current sharing reactor. Accordingly, a weight savings of approximately 8%-10% may be realized compared to conventional filter inductor assemblies. With reference now to FIG. 2A, a parallel semiconductor switching system 100 including a filter inductor 102 configured to provide current sharing is illustrated according to a non-limiting embodiment. The parallel semiconductor switching system 100 includes the current-sharing filter inductor 102, an input filter circuit 104, and a plurality of switching circuits 106a-106b. In at least one embodiment, the input filter circuit 104 includes a first and second capacitor branches connected in parallel with respect to one another. The first capacitor branch includes a first capacitor (C1) and a second capacitor (C2) connected in series with each other. A ground potential (G1) is center-tapped between the first and second capacitors (C1, C2). The second branch includes a third capacitor (C3) connected in parallel with the first and second capacitors (C3). The first and second capacitors (C1, C2) can receive a high-voltage input delivered via unshielded wires. The switching circuits 106a-106b each includes a plurality of individual semiconductor switches such as, for example, an insulated gate bipolar junction transistor (IGBT). In at least one embodiment illustrated in FIG. 2A, each switching circuit 106a-106b is configured as a two-level switch arrangement. The first switching circuit 106a includes a first semiconductor switch 108a and a second semiconductor switch 108c. The emitter of the first semiconductor switch 108a is connected to the collector of the second semiconductor switch 108c. The second switching circuit 106b includes a third semiconductor switch 108b and a fourth semiconductor switch 108d. The emitter of the third semiconductor switch 108b is connected to the collector of the fourth semiconductor switch 108d. In at least one embodiment, each semiconductor switch 108a-108d may include a diode having a cathode connected to the collector and an anode connected to the emitter.

The current-sharing filter inductor 102 (hereinafter referred to as the filter inductor 102) is configured to share current without requiring an additional individual current sharing reactor separately connected to the filter inductor 102 as required in conventional systems. The filter inductor 102 includes a first winding 110a and a second winding 110b. In at least one embodiment, the windings 110a-110b may serve as differential mode inductors, for example.

The first winding 110a includes a first input terminal (a) and a first output terminal (a'). The first input terminal (a) is operatively connected with the first switching circuit 106a. That is, the first input terminal (a) is connected in common with both the emitter of the first semiconductor switch 108a and the collector of the second semiconductor switch 108c. In this manner, the first input terminal (a) delivers a first current (I_{A}), which is output from the first switching circuit 106a, through the first winding 110a and to the first output terminal (a'). The second winding 110b includes a second input terminal (b) and a second output terminal (b'). The second input terminal (b) is operatively connected with the second switching circuit 106b. That is, the second input terminal (b) is connected in common with both the emitter of the third semiconductor switch 108b and the collector of the fourth semiconductor switch 108d. In this manner, the second input terminal (b) delivers a first current (I_{B}), which output from the second switching circuit 106b, through the second winding 110b and to the second output terminal (b').

According to a non-limiting embodiment, the first output terminal (a') and the second output terminal (b') are connected to one another to form a common node 112. As such, the output current (I_{A}) delivered from the first output terminal (a') to the load, *e.g*., motor, is approximately (I_{A}+I_{B})/2. In a similar manner, the output current (I_{B}) delivered from the second output terminal (b') to the load, *e.g*., motor, is also approximately (I_{A}+I_{B})/2. Accordingly, the common node 112 is capable of delivering a high-power combined current (I_{L}) to drive a load such as, for example, a high-power motor. Although terminals "a" and "b" are described as inputs, it should be appreciated that the terminals (a, b) and output terminals (a', b') may be interchangeable, *i.e*., terminals a' and b' may be utilized as input, while terminals a and b may be utilized as outputs. Additionally, it should be appreciated that any number of switching circuits (N) may be paralleled in the same fashion, and in a similar manner the output current delivered by each of the paralleled circuits is approximately the average of their sum.

Turning to FIG. 2B, an equivalent circuit diagram of the filter inductor 107 included in the parallel semiconductor switching system of FIG. 2A is illustrated according to a non-limiting embodiment. As mentioned above the first input terminal (a) receives a first current output from the first switching circuit 106a, and the second input terminal (b) receives a second current from the second switching circuit 106b. The equivalent circuit 107 illustrates that the single physical filter inductor component 107 may be functionally described by an electrical circuit comprised by a first inductor (La) 114a, a second inductor (Lb) 114b, and a lump filter inductance (L) 116.

The first inductor (La) 114a utilizes the first input terminal (a) to receive the first current signal (I_{A}) from the first switching circuit 106a, while the second inductor (Lb) 114b utilizes the second input terminal (b) to receive the second current signal (I_{B}) from the second switching circuit 106b. The inductor output (aa) of the first inductor (La) 114a is connected in common with the inductor output (bb) of the second inductor (Lb) 114b.

As further illustrated in FIG. 2B, the lump filter inductance (L) 116 includes an input 115 connected in common with both the inductor inputs (aa, bb), and an output 117 connected to the load, *e.g*., a high-powered motor). The equivalent circuit 107, therefore, illustrates that the first inductor 114a models a first leakage inductance (La) associated with the first winding 110a (a-a'), while the second inductor 114b models a second leakage inductance (Lb) associated with the second winding 110 (b-b'). In at least one embodiment, the first and second leakage inductances (La, Lb) may be approximately 2% of the lump inductance (L). Accordingly, the lump inductance (L) provides fundamental load current-sharing, which equalizes stress on the switching circuits 106a-106b.

At least one embodiment provides that the first leakage inductance (La) equals, or substantially equals, the second leakage inductance (Lb). In this manner, the sum of the leakage inductances La + Lb may serve as a current sharing reactor that is inherently built-in or integrated with the filter inductor 107. In this manner, the sum of the leakage inductances (La+Lb) may limit current circulating within the switching circuits 106a-106n.

In addition, unlike conventional filter inductors, the structure of the filter inductor 107 according to at least one non-limiting embodiment provides an integrated current sharing reactor, thereby eliminating the need to connect a separate and individual current sharing reactor to the filter inductor 107. Accordingly, the overall weight of the filter inductor 107 may be reduced by approximately 8%-10%.

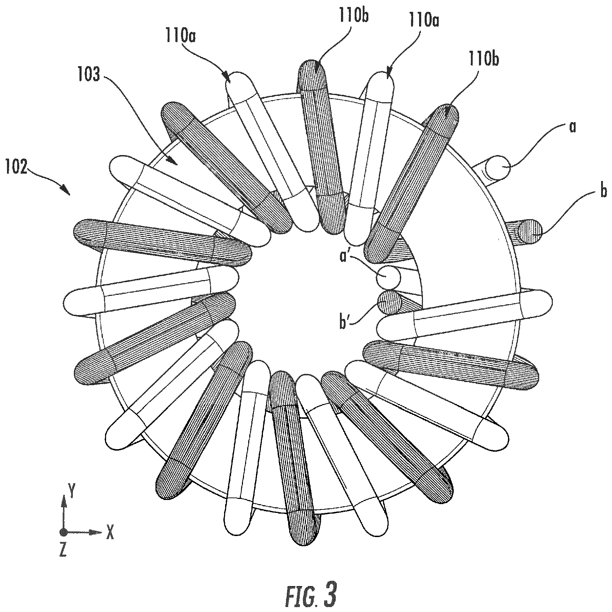

Turning to FIG. 3, a filter inductor 102 capable of providing current sharing is illustrated according to a non-limiting embodiment. The filter inductor 102 includes two individual and independent windings, *i.e*., a first winding 110a and a second winding 110b, formed around a core element 103. In at least one embodiment, the core element 103 is formed from various materials such as iron, for example, and has an annulus shape. Accordingly, the wrapped first and second windings 110a-110b defines a filter inductor having a toroid shape.

The first winding 110a extends from a first proximate terminal end (*e.g*., a first input) to a first distal terminal end (*e.g*., a first output). The second winding 110b extends from a second proximate terminal end (*e.g*., a second input) to an opposing second distal terminal end (*e.g*., a second output). The first and second windings 110a-110b are configured to deliver current that is half the total current. Since the current through each set of winding is half of the total, the conductor cross-section area is half. According to at least one embodiment, the windings wrap around the core element 103 in the same direction and have an identical number of turns as further illustrated in FIG. 3. In addition, the first and second windings 110a-110b may be formed of an identical type of material such as, for example, copper.

As described above, each winding defines an input terminal and an output terminal. Still referring to FIG. 3, the first winding 110a includes a first input terminal (a), *e.g*., a first proximate terminal end (a) and a first output terminal (a'), *e.g*., a first distal terminal end (a'), while the second winding 110b includes a second input terminal (b), *e.g*., a second proximate terminal end (b) and a second output terminal (b'), *e.g*., a second distal terminal end (b'). It should be appreciated, however, that the input and output terminals may be interchangeable. For example, the distal terminal ends (*e.g*., a' and b') may be utilized as input terminals, while the proximate terminal ends (*e.g*., a and b) may be utilized as output terminals.

According to a non-limiting embodiment, the first and second windings 110a-110b are wound around the core element 103 so as to form an alternating sequential arrangement with respect to one another. For example, a portion of the first winding 110a is directly interposed between adjacent portions of the second winding 110b, and vice-versa. In this manner, the first proximate terminal end (a) and first distal terminal end (a') is interposed between adjacent portions of the second winding 110b. In a similar manner, the second proximate terminal end (b) and second distal terminal end (b') is interposed between adjacent portions of the first winding 110a.

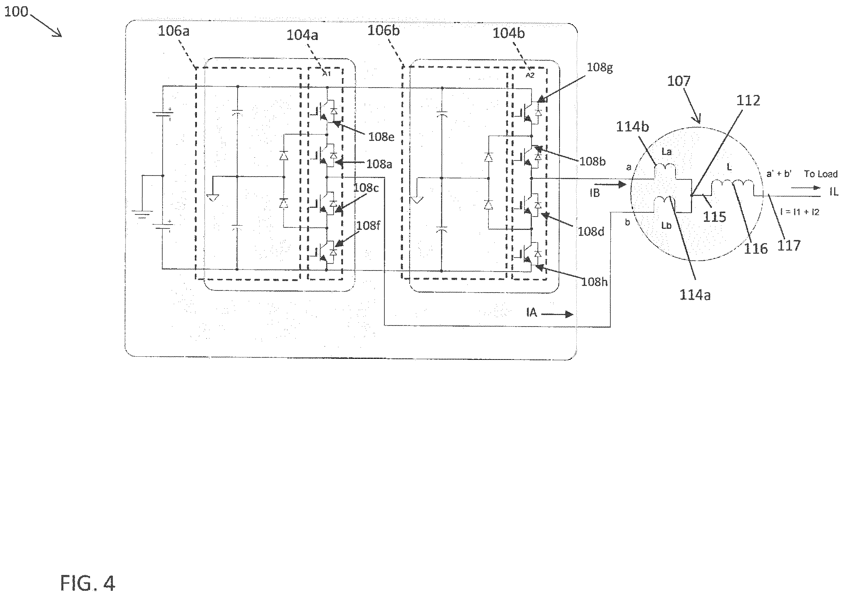

In addition, the filter inductor 102 is not limited to only two windings 110a-110b. For example, if four switching circuits 110a-110d the filter inductor 102 includes four windings 110a-110d. Accordingly, the filter inductor 102 may utilize a toroid-shaped core 103 that may maintain its shape as the number of windings increase. Turning now to FIG. 4, a multi-level parallel semiconductor switching system 100 including a filter inductor (illustrated as an equivalent circuit) 107 according to another non-limiting embodiment. The multi-level parallel semiconductor switching system 100 operates as described above in that the filter inductor is configured to share current while also providing a built-in, *i.e*., integrated, current sharing reactor. As further illustrated in FIG. 4, the multi-level parallel semiconductor switching system 100 may be constructed as a three-level parallel semiconductor switching system 100.

In this case, each switching circuit 106a-106b includes a pair of additional semiconductor switches. For example, the first switching circuit 106a includes a first outer semiconductor switch 108e and a second outer semiconductor switch 108f. The first outer semiconductor switch 108e includes a collector connected to a first voltage potential, *e.g*., a positive voltage (+V), and an emitter connected to the collector of the first semiconductor switch 108a. The second outer semiconductor switch 108f includes a collector connected to the emitter of the second semiconductor switch 108c, and an emitter connected to a second voltage potential, *e.g*., the negative voltage (-V). Similarly, the second switching circuit 106b includes a third outer semiconductor switch 108g and a fourth outer semiconductor switch 108h. The third outer semiconductor switch 108g includes a collector connected to the first voltage potential, *e.g*., a positive voltage (+V) and the collector of the first outer semiconductor switch 108e. The emitter of the third outer semiconductor switch 108g is connected to the collector of the third semiconductor switch 108b. The fourth outer semiconductor switch 108h includes a collector connected to the emitter of the fourth semiconductor switch 108d. The collector of the fourth outer semiconductor switch 108h is connected to the emitter of the second outer semiconductor switch 108f, and the second voltage potential, *e.g*., the negative voltage (-V). Accordingly, the first inductance leakage (La) associated with the first winding 110a of the filter inductor 107 is equal to, or substantially equal, to the second inductance leakage (Lb) associated with the winding 110b. In at least one embodiment, the first inductance leakage (La) is approximately 0.02 L.

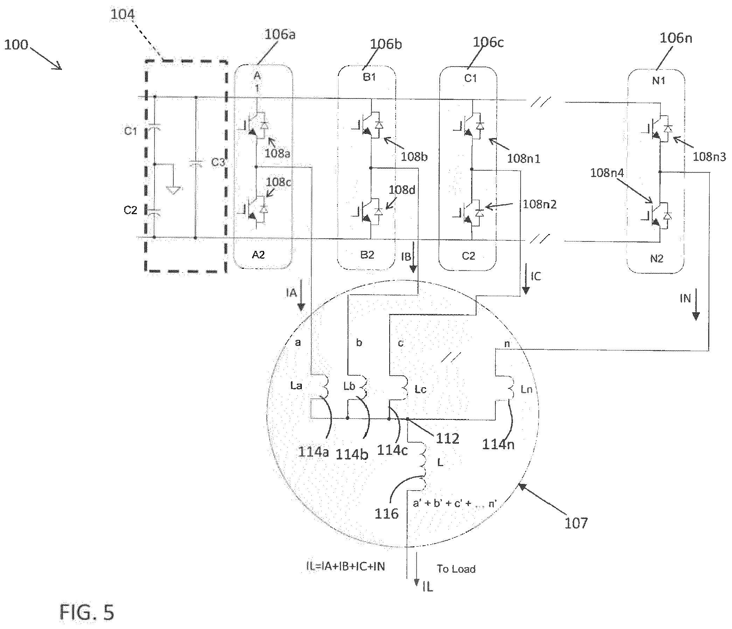

Referring to FIG. 5, a parallel semiconductor switching system 100 including a filter inductor 107 configured to provide current sharing is illustrated according to another non-limiting embodiment. As described in detail above, the filter inductor 107 is configured to share current while also providing a built-in, *i.e*., integrated, current sharing reactor. As illustrated in FIG. 5, the parallel semiconductor switching system 100 may include any number (nₛ) of switching circuits 106a-106n connected in parallel with one another. Accordingly, the number (n_{w}) of inductors 114a (La) - 114n (Ln) of the filter inductor 107 matches the number (nₛ) of switching circuits 106a-106n, *i.e*., n_{w} = nₛ. In at least one embodiment, each inductor 114a (La) - 114n (Ln) is connected in parallel with respect to one another, and each has a cross-section defined as 1/n of the total number (n_{w}) of inductors. The parallel arrangement of the windings 110a-110n allows for increased surface area so as to extract a greater amount of heat induced from high-power current flow.

Still referring to FIG. 5, the equivalent circuit 107 illustrates that each inductor 114a (La) - 114n (Ln) includes an input aa-nn coupled to an output of a respective switching circuit 106a-106n, and an output coupled together at a common node 112. A lump inductance filter (L) 116 includes input connected to the common node 112 and an output connected to a load such as, for example, a high-powered motor. The output of the lump inductance filter (L) 116 may be realized as the sum of the outputs (a'-n') of each respective winding 110a-110n. Accordingly, the output current (I_{L}) delivered to the load is the sum of the currents (I_{A}-I_{N}) delivered through each winding 110a-110n.

While the present disclosure has been described in detail in connection with only a limited number of embodiments, it should be readily understood that the present disclosure is not limited to such disclosed embodiments. Rather, the present disclosure can be modified to incorporate any number of variations, alterations, substitutions or equivalent arrangements not heretofore described, but which are commensurate with the spirit and scope of the present disclosure. Additionally, while various embodiments of the present disclosure have been described, it is to be understood that aspects of the present disclosure may include only some of the described embodiments. Accordingly, the present disclosure is not to be seen as limited by the foregoing description, but is only limited by the scope of the appended claims.

## Claims

1. A parallel semiconductor switching system, comprising:
an input filter circuit configured to output at least one filtered voltage;
a plurality of switching circuits (106a, 106b) configured to receive the at least one filtered voltage , each switching circuit among the plurality switching circuits configured to output a respective current; and
a current-sharing filter inductor including a plurality of windings (110a-n), each winding having a winding input and a winding output, the winding input of each winding being connected to a switching output of a respective switching circuit, and the winding output of each winding being connected to one another to form a common node,
wherein the common node (112) is connected directly to a load such that the current-sharing filter inductor is configured to share each current output from the plurality of switching circuits so as to deliver a combined current signal to the load.

2. The parallel semiconductor switching system of claim 1, wherein each winding (110a-n) is connected in parallel with one another.

3. The parallel semiconductor switching system of claim 2, wherein the current-sharing filter operates according to an integrated current sharing reactor.

4. The parallel semiconductor switching system of claim 2 or 3, wherein the plurality of switching circuits (106a-b) includes at least three switching circuits.

5. The parallel semiconductor switching system of claim 2, 3 or 4, wherein each switching circuit (106a-b) includes a plurality of semiconductor switches.

6. A filter inductor configured to share current generated by a plurality of switching circuits (106a-b) included in a parallel semiconductor switching system, the filter inductor comprising:
a core element;
a first winding (110a) wrapped around the core element, the first winding (110a) extending from a first proximate terminal end to an opposing first distal terminal end; and
a second winding (110b) wrapped around the core element, the second winding (110b) extending from a second proximate terminal end to an opposing second distal terminal end,
wherein the first and second windings (110a, b) are wrapped around the core element at an alternating sequential arrangement with respect to one another.

7. The filter inductor of claim 6, wherein the first winding (110a) is separate and independent from the second winding (110b).

8. The filter inductor of claim 6 or 7, wherein the core element has an annulus shape such that the filter inductor defines a toroidal shape.

9. The filter inductor of claim 8, wherein the first winding (110a) winds around the core element in a first direction and the second winding (110b) winds around the core element in a second direction that is substantial equal to the first direction.

10. The filter inductor of claim 8, wherein the first proximate terminal end and the first distal terminal end are directly interposed between opposing portions of the second winding (110b), and the second proximate terminal end and the second distal terminal end are directly interposed between opposing portions of the first winding (110a).
